# EUROPEAN PATENT SPECIFICATION

(11) **EP 2 231 803 B1**
(45) Date of publication and mention of the grant of the patent: **14.09.2011**
(21) Application number: 08861688.3
(22) Date of filing: 04.12.2008
(51) Int. Cl.: C09J 9/02, H05K 3/32

(54) **CONDUCTIVE ADHESIVE PRECURSOR, METHOD OF USING THE SAME, AND ARTICLE**
VORGÄNGER FÜR LEITFÄHIGEN KLEBSTOFF, VERWENDUNG UND ERZEUGNIS
PRÉCURSEUR D'ADHÉSIF CONDUCTEUR, SON PROCÉDÉ D'UTILISATION ET ARTICLE ASSOCIÉ

(30) Priority: 18.12.2007 US 14479 P
(43) Date of publication of application: 29.09.2010
(73) Proprietor: 3M Innovative Properties Company, Saint Paul, MN 55133-3427 (US)
(72) Inventor: KROPP, Michael A.,, Saint Paul, Minnesota 55133-3427 (US); ZENNER, Robert L.D.,, Saint Paul, Minnesota 55133-3427 (US)
(74) Representative: Voortmans, Gilbert J.L.
(86) International application number: PCT/US2008/085464
(87) International publication number: WO 2009/079216

(56) References cited:
- US-A1- 2003 180 508
- US-A1- 2007 018 315
- US-B1- 6 214 460

## Description

### BACKGROUND

There are many applications in electronic assemblies that require electrically conductive interconnects. Integrated circuit dies and stiffeners often need to be grounded, and are commonly bonded to substrates using conductive adhesives. Conductive adhesive pastes are often used for these applications. However, these pastes do not provide sufficient green strength to hold substrates in place without mechanical fixturing. Also, the pastes can squeeze out during placement or cure, leading to undesirably large adhesive footprints.

Conductive film adhesives have also been used for forming conductive bonds, but typically require die cutting, which is not well-suited for short run applications, and which also typically generates substantial quantities of expensive scrap.

### SUMMARY

The present disclosure describes a flowable conductive adhesive (typically printable) that can be B-staged using actinic radiation, and then thermally cured to securely bond two substrates. The conductive adhesive provides electrical conductivity between the two substrates.

In one aspect, the present disclosure provides a conductive adhesive precursor comprising:
a) from 20 to 50 percent by weight of at least one polyepoxide,
b) from 20 to 50 percent by weight of at least one free-radically polymerizable (meth)acrylate,
c) from 20 to 40 percent by weight of conductive fibers, and
d) from 2 to 10 percent by weight of conductive substantially spherical particles, wherein the percent by weight of components a) to d) is based on the total weight of components a) to d);
e) an effective amount of at least one thixotrope;
f) an effective amount of photoinitiator for the at least one free-radically polymerizable (meth)acrylate; and
g) an effective amount of thermal curative for the at least one polyepoxide. In another aspect, the present disclosure provides a method of conductively bonding a first substrate to a second substrate comprising:
   applying a conductive adhesive precursor to the first substrate, the conductive adhesive precursor comprising:
      a) from 20 to 50 percent by weight of at least one polyepoxide,
      b) from 20 to 50 percent by weight of at least one free-radically polymerizable (meth)acrylate,
      c) from 20 to 40 percent by weight of conductive fibers, and
      d) from 2 to 10 percent by weight of conductive substantially spherical particles, wherein the percent by weight of each of components a) to d) is based on the total weight of components a) to d),
      e) an effective amount of at least one thixotrope,
      f) an effective amount of initiator for the at least one free-radically polymerizable (meth)acrylate, and
      g) an effective amount of thermal curative for the at least one polyepoxide;
   free-radically polymerizing at least a portion of the at least one free-radically polymerizable (meth)acrylate to convert the conductive adhesive precursor into a B-staged conductive adhesive precursor;
   contacting the second substrate with the B-staged conductive adhesive precursor; and
   curing at least a portion of the at least one polyepoxide.

In yet another aspect, the present disclosure provides an article comprising a first substrate bonded to a second substrate by a conductive adhesive, the conductive adhesive comprising a reaction product of a conductive adhesive precursor comprising:
the conductive adhesive comprising a reaction product of a conductive adhesive precursor comprising:
   a) from 20 to 50 percent by weight of at least one polyepoxide,
   b) from 20 to 50 percent by weight of at least one free-radically polymerizable (meth)acrylate,
   c) from 20 to 40 percent by weight of conductive fibers, and
   d) from 2 to 10 percent by weight of substantially spherical conductive particles, wherein the percent by weight of components a) to d) is based on the total weight of components a) to d);
   e) an effective amount of at least one thixotrope;
   f) an effective amount of initiator for the at least one free-radically polymerizable (meth)acrylate; and
   g) an effective amount of thermal curative for the at least one polyepoxide.

In certain embodiments, the at least one free-radically polymerizable (meth)acrylate comprises at least one mono(meth)acrylate and at least one poly(meth)acrylate. In certain embodiments, the conductive adhesive precursor is essentially solvent-free. In certain embodiments, the B-staged conductive adhesive precursor is tacky. In certain embodiments, the first substrate and the second substrate comprise electronic device components.

Materials and methods according to the present disclosure overcome the aforementioned shortcomings of conductive adhesive pastes and films. For example, the conductive adhesive precursor can be dispensed, stenciled, or screen printed onto a substrate, then B-staged to convert the flowable conductive adhesive precursor to a, typically conductive, tacky or non-tacky adhesive decal on the printed substrate. This conversion reduces squeeze out and flow of the adhesive during the attachment of the second conductive substrate, which is attached with applied pressure and, optionally, heat. Moreover since it is possible to apply the conductive adhesive precursor only where needed, scrap can be reduced or even essentially eliminated.

The joined conductive substrates can then be exposed to a thermal post-cure cycle that completes the cure. The resulting construction is two substrates with conductive surfaces strongly adhered and showing good electrical interconnection. Conductive adhesives according to the present disclosure are typically isotropic, although this is not a requirement.

Advantageously, conductive adhesive precursors according to the present disclosure contain specific conductive fillers (for example, fibers and substantially spherical particles) that allow for high conductivity at low enough filler levels to still allow penetration of actinic (for example, ultraviolet (UV)) radiation through the entire thickness of the printed or dispensed conductive adhesive precursor. This enables photocuring, if desired, of the free-radically polymerizable components (for example, (meth)acrylates).

As used herein, unless otherwise specified:
"conductive" means electrically conductive;
"tacky" means slightly adhesive or gummy to the touch;
"thixotrope" means an additive used to impart thixotropy to a coating material; and
"thixotropy" refers to the property of a material which enables it to reversibly stiffen or thicken upon standing a relatively short time, but upon agitation or manipulation to change to a flowable consistency.

The details of one or more embodiments are set forth in the accompanying drawing and description below. Other features, objects, and advantages will be apparent from the description and drawings, and from the claims.

### BRIEF DESCRIPTION OF THE DRAWING

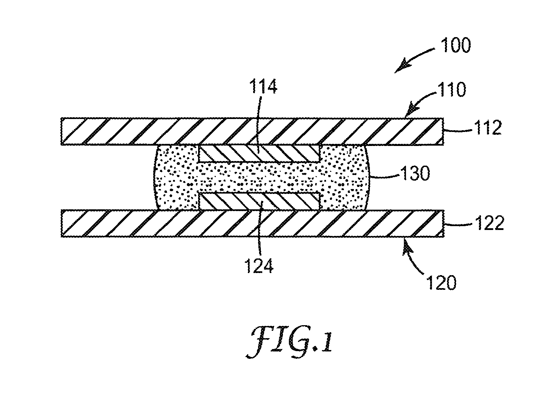

Fig. 1 is a schematic cross-sectional side view of an exemplary article according to one aspect of the present disclosure.

### DETAILED DESCRIPTION

Conductive adhesive precursors according to the present disclosure include curable components and conductive components. The curable components comprise at least one polyepoxide and at least one free-radically polymerizable (meth)acrylate.

As used herein, the term "polyepoxide" means a compound that has more than one epoxy group. Useful polyepoxides include, for example, alicyclic and aromatic polyepoxides.

Examples of useful alicyclic polyepoxides include monomeric alicyclic polyepoxides, oligomeric alicyclic polyepoxides, and polymeric alicyclic polyepoxides. Exemplary useful alicyclic polyepoxides monomers include epoxycyclohexanecarboxylates such as, for example, 3,4-epoxycyclohexylmethyl 3,4-epoxycyclohexanecarboxylate (for example, as "ERL-4221" from Dow Chemical Co., Midland, MI) and 3,4-epoxy-2-methylcyclohexylmethyl 3,4-epoxy-2-methylcyclohexanecarboxylate; diglycidyl ether of cyclohexanedimethanol (for example, as "HELOXY 107" from Hexion Specialty Chemicals, Columbus, OH); and hydrogenated bisphenol A diglycidyl ether (for example, as "EPONEX 1510" from Hexion Specialty Chemicals).

Useful aromatic polyepoxides include, for example, monomeric aromatic polyepoxides, oligomeric aromatic polyepoxides, and polymeric aromatic polyepoxides. Exemplary aromatic polyepoxides include the polyglycidyl ethers of polyhydric phenols such as bisphenol A-type resins and their derivatives; epoxy cresol-novolac resins; Bisphenol-F resins and their derivatives; epoxy phenol-novolac resins; and glycidyl esters of aromatic carboxylic acids (for example, phthalic acid diglycidyl ester, isophthalic acid diglycidyl ester, trimellitic acid triglycidyl ester, and pyromellitic acid tetraglycidyl ester), and mixtures thereof. Commercially available aromatic polyepoxides include, for example, those aromatic polyepoxides having the trade designation "EPON" (for example, "EPON 828", "EPON 862", "EPON 1001F, "EPON DPL-862" and "EPON HPT-1079"), available, for example, from Hexion Specialty Chemicals; and aromatic polyepoxides having the trade designations "DER", "DEN" (for example, "DEN 438", and DEN 439"), and "QUATREX", available, for example, from Dow Chemical Co.

The at least one polyepoxide is present in an amount of from 20 to 50 percent by weight, typically in an amount of from 20 to 40 percent by weight, and more typically in an amount of from 25 to 35 percent by weight, based on the combined total weight of the at least one polyepoxide, at least one free-radically polymerizable (meth)acrylate, conductive fibers, and conductive substantially spherical particles.

An effective amount of thermal curative for the at least one polyepoxide is included in the conductive adhesive precursor such that it can be sufficiently cured to develop a strong bond between the two substrates. Hence, the term "effective amount of thermal curative" refers to at least a minimum quantity. The precise amount will necessarily vary due to formulation and curing variables, but it is typically 10 percent by weight or less based on the total weight of the conductive adhesive precursor.

Useful thermal curatives for the polyepoxide(s) include acid curatives and base curatives. Examples of useful curing agents include boron trifluoride complexes such as, for example, BF₃ · Et₂O and BF₃ · H₂NC₂H₄OH; polyamines such as, for example, bis(4-aminophenyl)sulfone, bis(4-aminophenyl) ether, and 2,2-bis(4-aminophenyl)propane; aliphatic and aromatic tertiary amines such as, for example, dimethylaminopropylamine; fluorenediamines; and modified amine curing agents such as those commercially available from Air Products and Chemicals, Allentown , PA, under the trade designations "ANCAMINE" (for example, "ANCAMINE 2337S", "ANCAMINE 2014", and "ANCAMINE 2441 ") and from Ajinimoto, Japan under the trade designation "AJICURE" (for example, "AJICURE PN23" and "AJICURE M353"); imidazoles such as, for example, methylimidazole and 2,4-diamino-6-(2'-methylimidazolyl-(1'))-ethyl-s-triazine hexakis(imidazole)nickel phthalate); hydrazines such as, for example, adipohydrazine; guanidines, such as, for example, tetramethylguanidine and dicyandiamide (cyanoguanidine, also commonly known as DiCy); and combinations thereof.

The at least one free-radically polymerizable (meth)acrylate comprises one or more mono(meth)acrylate(s) and/or poly(meth)acrylate(s). As used herein, the term "(meth)acryl" encompasses both methacryl and/or acryl. For example, a poly(meth)acrylate may have only acrylate groups, only methacrylate groups, or a combination of acrylate and methacrylate groups.

Useful free-radically polymerizable mono(meth)acrylates include, for example, phenoxyethyl (meth)acrylate, 2-hydroxyethyl (meth)acrylate, and (meth)acrylic esters of non-tertiary alcohols having from about 4 to about 12 carbon atoms in the alcohol moiety, and combinations thereof. Included in this latter class of (meth)acrylic esters are butyl (meth)acrylate, hexyl (meth)acrylate, 2-ethylhexyl (meth)acrylate, octyl (meth)acrylate, isooctyl (meth)acrylate, decyl (meth)acrylate, and dodecyl (meth)acrylate.

Useful free-radically polymerizable poly(meth)acrylates include, for example, 1,6-hexanediol di(meth)acrylate, trimethylolpropane tri(meth)acrylate, 1,2-ethylene glycol di(meth)acrylate, pentaerythritol tetra(meth)acrylate, and urethane and epoxy di(meth)acrylate oligomers available under trade designation "EBECRYL" (for example, "EBECRYL 230", "EBECRYL 3605", and "EBECRYL 8804") from UCB Radcure, Smyrna, GA, and "CN" (for example, "CN 104") from Sartomer Co., Exton, PA, and combinations thereof.

Typically, a combination of free-radically polymerizable mono(meth)acrylate(s) and poly(meth)acrylate(s) is used. In some embodiments, the free-radically polymerizable (meth)acrylate(s) are selected such that polymerization results in a tacky B-staged conductive adhesive precursor (for example, a pressure-sensitive adhesive), although this is not a requirement.

The at least one free-radically polymerizable (meth)acrylate is present in an amount of from 20 to 50 percent by weight, typically in an amount of from 20 to 40 percent by weight, and more typically in an amount of from 25 to 35 percent by weight, based on the combined total weight of the at least one polyepoxide, at least one free-radically polymerizable (meth)acrylate, conductive fibers, and conductive substantially spherical particles.

An effective amount of photoinitiator for the at least one free-radically curable (meth)acrylate is included in the conductive adhesive precursor such that it can be sufficiently cured to B-stage (that is, sufficiently cured that it will soften but not melt if heated) the conductive adhesive precursor upon photopolymerization. Hence, the term "effective amount of photoinitiator" refers to at least a minimum quantity. The precise amount will necessarily vary due to formulation and curing variables, but it is typically 10 percent by weight or less based on the total weight of the conductive adhesive precursor. Typically, lower molecular weight photoinitiators are used in total amounts of about 0.001 to about 4 percent by weight based on the total weight of the conductive adhesive precursor, while higher molecular weight photoinitiators are used in total amounts of about 0.1 percent to about 8 percent by weight based on the total weight of the conductive adhesive precursor.

Useful photoinitiators include, for example, substituted acetophenones such as 2,2-dimethoxy-2-phenylacetophenone; benzoin ethers such as benzoin methyl ether and substituted benzoin ethers such as anisoin methyl ether; substituted alpha-ketols such as 2-methyl-2-hydroxypropiophenone; benzophenone and its derivatives; phosphine oxides; polymeric photoinitiators; and combinations thereof. Many useful photoinitiators are commercially available from sources such as, for example, Ciba Geigy Corp., Tarrytown, NY, under the trade designations "IRGACURE" (for example, "IRGACURE 184", "IRGACURE 651", "IRGACURE 369", and "IRGACURE 907") and "DAROCUR" (for example, "DAROCUR 1173", "DAROCUR MBF", "DAROCUR TPO", and "DAROCUR 4265"), and under the trade designation "ESCACURE" from Sartomer Co., Exton, PA.

The conductive components include conductive fibers and conductive substantially spherical particles.

The conductive fibers are present in an amount of from 20 to 40 percent by weight, typically in an amount of from 20 to 35 percent by weight, and more typically in an amount of from 24 to 28 percent by weight, based on the combined total weight of the at least one polyepoxide, at least one free-radically polymerizable (meth)acrylate, conductive fibers, and conductive substantially spherical particles.

Suitable conductive fibers include virtually any fiber material having a bulk resistivity below about 50 microohm-centimeters (µΩ -cm), typically below about 4 µΩ-cm. Examples of conductive fibers include fibers of conductive metals such as, for example, copper, aluminum, silver, and gold, and alloys thereof. Conductive fibers can also be prepared by modifying electrically insulating fibers, such as by introducing a conductivity-imparting agent to a natural or synthetic polymer, for example, by incorporating metal particles into the fiber. Conductive fibers may also be formed by metal plating, or otherwise coating, onto a metal fiber or metal plating onto a non-metal fiber core. Metal plating for fiber includes copper, nickel, cobalt, silver, gold, palladium, platinum, ruthenium, and rhodium, and alloys of thereof. Non-metal fiber cores include carbon, graphite, glass, polyester, and other synthetic materials. Exemplary metal-plated fibers include nickel-plated carbon fibers, polyethylene fiber coated with gold, acrylic fibers plated with gold, nylon fibers coated with rhodium, and silver coated glass fibers (for example, as "CONDUCT-O-FIL SILVER COATED E-GLASS FIBER SF82TF20" from Potters Industries, Valley Forge, PA). Exemplary metal fibers include stainless steel fiber, copper fiber, silver fiber, aluminum fiber, and combinations thereof. Combinations of conductive fibers may also be used.

As used herein the term "substantially spherical particles" refers to regularly shaped, rounded particles that resemble spheres. The conductive substantially spherical particles are present in an amount of from 2 to 10 percent by weight, typically in an amount of from 2 to 8 percent by weight, and more typically in an amount of from 2 to 5 percent by weight, based on the combined total weight of the at least one polyepoxide, at least one free-radically polymerizable (meth)acrylate, conductive fibers, and conductive substantially spherical particles.

Examples of conductive substantially spherical particles include metal spheres such as aluminum, nickel, gold, copper, or silver, and coated copper, nickel, polymeric, or glass spheres coated with conductive coatings such as aluminum, gold, silver, copper, or nickel. Also useful are substantially spherical solder particles such as lead/tin alloys in varying amounts of each metal, for example, as available from Sherritt Gordon Limited, Canada. Examples of commercially available electrically conductive particles include conductive nickel spheres available from Novamet, Wykoff, NJ and silver coated glass spheres (for example, as "CONDUCT-O-FIL S-3000-S3MM" from Potters Industries).

Combinations of conductive substantially spherical particles may also be used.

In addition to the foregoing components, conductive adhesive precursors according to the present disclosure include an effective amount of at least one thixatrope. As used herein, term "effective amount" means a sufficient quantity that the conductive adhesive precursor rapidly develops shape stability the essentially eliminates flow after application after application of the conductive adhesive precursor to a substrate. Thixotropes are well known in the art, and many are widely commercially available. Examples of suitable thixatropes include treated and untreated fumed silicas such as those available under the trade designation "CAB-O-SIL" from Cabot Corp. of Boston, MA, or under the trade designation "AEROSIL" from Evonik Industries, Essen, Germany.

While not required, the conductive adhesive precursors may further contain minor amounts (for example, less than about 20 percent by weight) of one or more additive(s) such as, for example, tackifiers (for example, to facilitate adhesion to non-polar substrates), dyes, pigments, thermoplastic polymers, non-conductive fillers, and /or coupling agents.

While solvent may be included in the conductive adhesive and/or its precursor, it is generally desirable to limit the amount to a minor amount (for example, less than about 20 percent by weight). Advantageously, the conductive adhesive and/or its precursor may be formulated as essentially solvent-free, or even totally free of solvent. As used herein, the term "essentially solvent-free" means containing less than about one percent by total weight of solvent. The term "solvent" refers collectively to any volatile organic compound(s) (not reactive with other components that are present) added for the purpose of solvating at least some of the remaining components of a composition. Examples include toluene, heptane, ethyl acetate, methyl ethyl ketone, acetone, and mixtures thereof.

In practice, the conductive adhesive precursor is typically prepared from its constituent parts using a conventional mixing technique, for example, gentle rolling, roller milling, or ball milling. In some cases, it may be useful to heat the polyepoxide and/or free-radically polymerizable (meth)acrylates (for example, up to about 80° C) to facilitate mixing.

Conductive adhesive precursors according to the present disclosure can be used to conductively bond a first substrate to a second substrate. Typically, in such a process a conductive adhesive precursor according to the present disclosure is applied (for example, dispensed, stenciled, or screen printed) to a typically conductive portion of the first substrate (for example, a portion of a circuit trace). The conductive adhesive precursor is then exposed to actinic radiation (for example, ultraviolet and/or visible light) that decomposes at least a portion of the photoinitiator and causes polymerization of the at least one (meth)acrylate sufficient to result in a B-staged conductive adhesive precursor. Sources of actinic radiation include, for example, low, medium or high pressure mercury lamps, lasers, and xenon flash lamps. Next, the second substrate is brought into contact with the B-staged conductive adhesive precursor; and the combination is heated (for example, in an oven) under conditions (for example, time and temperature) to sufficiently cure the polyepoxide to achieve a secure conductive bond between the first and second substrates.

An exemplary such a bonded article is shown in Fig. 1, wherein an article 100 has first substrate 110 having support 112 with conducting element 114 thereon and second substrate 120 having support 122 with conducting element 124 thereon. The first and second substrates are bonded one to another by conductive adhesive 130 according to the present disclosure.

While any substrates may be used, typically at least a portion of the substrates will be conductive. Examples of useful substrates include components of electronic devices (for example, integrated circuits, LEDS, sockets), flex circuitry, and printed circuit boards.

Objects and advantages of this disclosure are further illustrated by the following non-limiting examples, but the particular materials and amounts thereof recited in these examples, as well as other conditions and, details, should not be construed to unduly limit this disclosure.

### EXAMPLES

Unless otherwise noted, all parts, percentages, ratios, etc. in the Examples and the rest of the specification are by weight.

**TABLE OF ABBREVIATIONS**

| ABBREVIATION | DESCRIPTION |
|---|---|
| ACR1 | phenoxyethyl acrylate available as "AGEFLEX PEA" from Ciba Specialty Chemicals, Tarrytown, NY. |
| ACR2 | Aliphatic urethane diacrylate, available as "EBECRYL 8804" from Cytec Surface Specialties, Smyrna, GA. |
| CFIB | SILVER COATED GLASS FIBER, powder resistivity 3.5 mohm-cm, mean particle size (length) = 130 micrometers, available as "CONDUCT-O-FIL SF8 2TF20" from Potters Industries, Valley Forge, PA. |
| CFIL CUR | Silver coated solid glass spheres, average particle size = 41 micrometers, available as "CONDUCT-O-FIL S3000-S3M" from Potters Industries. Cycloaliphatic amine curing agent available as "ANCAMINE 2441" from Air Products and Chemicals, Allentown, PA. |
| EP1 | difunctional bisphenol A/epichlorohydrin derived liquid epoxy resin, epoxide equivalent weight = 185-192 g/eq, available as "EPON 828" from Hexion Specialty Chemicals, Houston, TX, purified. |
| EP2 | bisphenol F/epichlorohydrin derived liquid epoxy resin, epoxide equivalent weight = 165-180 g/eq, available as"EPICLON 830" from Dainippon Ink and Chemicals, Tokyo, Japan. |
| EP3 | bisphenol A/epichlorohydrin derived liquid epoxy resin, epoxide equivalent weight = 180-190 g/eq, available as"EPICLON 840" from Dainippon Ink and Chemicals. |
| EP4 | liquid epoxy resin derived from epichlorohydrin and bisphenol F,. epoxide equivalent weight = 165-173 g/eq, available as"EPON 862" from Hexion Specialty Chemicals, purified. |
| FUMSIL | hydrophobic fumed silica, available under the trade designation "AEROSIL R 202" from Evonik Industries AG, Essen, Germany. |
| PI | photoinitiator (CAS No. 119313-12-1; 2-benzyl-2-dimethylamino-4-morpholinobutyrophenone, available as "IRGACURE 369" from Ciba Specialty , Tarrytown, NY) |

### EXAMPLE 1

ACR1 (27.6 parts), 1.4 parts of ACR2, 19 parts of EP1, 15 parts of EP2 were combined by mixing (rolling in a plastic bottle). To this mixture was added 4.6 parts of FUMSIL, 26.1 parts of CFIB, 3.3 parts of CFIL, 5.7 parts of CUR, and 0.3 parts of PI, with mixing in a centrifugal mixer marketed by Hauschild Engineering, Hamm, Germany as "DAC 600 FVZ SPEEDMIXER" operating at 2700 revolutions per minute (rpm) rpm resulting in Composition 1.

Composition 1 was stencil printed onto: a 2 mil (0.05 mm) thickness polyimide film with copper metallization plated with gold resulting in Sample (a), and the gold-plated side of a gold-plated PET polyester film (3 mil (80 micrometers) thickness), resulting in Sample (b), using a 3 mils (80 micrometers) thick metal stencil and an aluminum plate as a print blade. The films with the printed adhesives were passed two times through an ultraviolet (UV) lamp Fusion UV Systems lamp, model F300S, equipped with an "H bulb" available from Fusion UV Systems, Gaithersburg, MD, to obtain a total dose of 790 millijoules/centimeter² (mJ/cm²) in the UVA region of the spectrum.

After UV exposure, the printed Composition 1 had become tacky (that is, B-staged). For Samples (a) and (b) the B-staged adhesive was then bonded to an indium-tin-oxide (ITO)-coated side of an ITO-coated PET polyester film) (3 mils (0.08 mm) thickness) to test conductivity of the adhesive after cure. The ITO-coated film was pressed for 10 seconds onto the adhesive in a Young Technology's precision thermal press set at 25 pounds per square inch (0.2 MPa) and 55-65 °C. The samples were then placed between two sheets of stainless steel and cured by placing in an oven set at 120 °C for 30 minutes.

Conductivity was tested by probing the two substrate surfaces and measuring resistance through the adhesive using a model 73III multimeter marketed by Fluke Corporation, Everett, WA. Both laminated cured samples had an electrical resistance of 1.7 ohms or less indicative of a good electrical interconnect.

### EXAMPLE 2 and COMPARATIVE EXAMPLES A-C

A composition (Composition 2) was prepared by combining with mixing (rolling in a plastic bottle): 490 parts of ACR1, 10 parts of ACR2, 250 parts of EP2, 250 parts of EP3. To 243 parts of Composition 2 was added 19.5 parts of FUMSIL, and the combined ingredients were mixed for 2 minutes using a centrifugal mixer marketed by Hauschild Engineering as "DAC 600 FVZ SPEEDMIXER" operating at 2700 revolutions per minute rpm. CUR (24.2 parts) was added to the resultant mixture, which was then mixed for 2 minutes using a centrifugal mixer ("DAC 600 FVZ SPEEDMIXER") operating at 1900 rpm.

A photoinitiator solution was separately prepared from a one-to-one blend of ACR1 and PI, heated at 95 °C for 20 minutes to partially liquefy it.

This photoinitiator solution (2.6 parts) was combined with 252.5 parts of Composition 2, which was then mixed at rpm for 2 minutes using a centrifugal mixer ("DAC 600 FVZ SPEEDMIXER") operating at 1900 rpm resulting in Composition 3. Four formulations were prepared as shown in Table 1 (below).

**TABLE 1**

| EXAMPLE | FORMULATION | COMPOSITION 3, parts | CFIL, parts | CFIB, parts |
|---|---|---|---|---|
| COMPARATIVE EXAMPLE A | A | 71 | 0 | 29 |
| COMPARATIVE EXAMPLE B | B | 71 | 29 | 0 |
| EXAMPLE 2 | C | 71 | 3 | 26 |
| COMPARATIVE EXAMPLE D | D | 23 | 77 | 0 |

Each of the above formulations at rpm for 2 minutes using a centrifugal mixer ("DAC 600 FVZ SPEEDMIXER") operating at 2200 rpm. Formulations A, B, and C were vacuum degassed while slowly stirring for about 10 min. Formulation D was vacuum degassed without stirring for one hour.

Each formulation was stencil printed onto an interdigitated comb-patterned printed circuit board using a surface insulation resistance test circuit defined by the solder mask qualification board IPC-B-25A (see IPC-9201 Surface Insulation Resistance Handbook, July 1996, IPC, Northbrook, IL) with nickel-gold top layer metallurgy having an area of 0.5 inch (2.5 cm) by 1.25 inches (3.18 cm) made from stamped openings in 5.5 mils (130 micrometers) thick polyester film. The circuit pattern having an 0.5 millimeter line spacing was tested. The dispensed patterns of each formulation were B-staged by exposure to UV light using a Fusion UV Systems lamp, model F300S, equipped with an "H bulb", and operated at a conveyor speed of 20 feet/minute (6.1 m/min). The ultraviolet light dosage was measured using an energy meter ("UV POWER PUCK" from EIT,

Sterling, VA) at 485.4 mJ/cm² UV-A and 448.4 mJ/cm² UV-B. The connection resistance between the interdigitated patterns was measured with a model 73III multimeter from Fluke Corporation, Everett, WA. Four replicates were measured for each formulation. Results are reported in Table 2 (below).

**Table 2**

| EXAMPLE | CONNECTION RESISTANCE, ohms | | | |
|---|---|---|---|---|
| | Replicate 1 | Replicate 2 | Replicate 3 | Replicate 4 |
| COMPARATIVE EXAMPLE A | 1.88 x 10⁷ | 1.27 x 10⁷ | 2.1 | 7.00 x 10⁴ |
| COMPARATIVE EXAMPLE B | open | open | open | open |
| EXAMPLE 2 | 114.6 | 4.3 | 6.2 | 1.15 x 10⁷ |
| COMPARATIVE EXAMPLE C | 8.4 | 5.2 | 1.75 x 10⁶ | 19.5 |

As can be seen in Table 2, Example 2 and Comparative example C gave conductive B-staged compositions, thereby permitting testing (and potentially repair) of the electrical connection prior to subjecting them to thermal curing.

One set of B-stage printed boards (including two of the test patterns) were placed in an oven for 30 minutes at 150 °C to C-stage them. The connection resistance between the interdigitated patterns was measured again, and are reported in Table 3 (below).

**Table 2**

| EXAMPLE | Connection Resistance, ohms | |
|---|---|---|
| | Replicate 1 | Replicate 2 |
| COMPARATIVE EXAMPLE A | 0.5 | 0.3 |
| COMPARATIVE EXAMPLE B | open | open |
| EXAMPLE 2 | 0.5 | 0.7 |
| COMPARATIVE EXAMPLE C | 0.1 | 0.1 |

The same pattern of each of Example 2 and Comparative Examples A-C was stenciled onto bare polyester film. These patterns were also exposed to the abovementioned UV light source. A second polyester film was placed over each of the printed formulations and pressed together by applying pressure with a weighted roller (4.5 lbs, (2.2 kg)). The two polyester films were then peeled apart to demonstrate the integrity of the B-Staged film. In the case of Formulations Comparative Examples A and B, and Example 2 the pattern was separated from the top polyester layer as a complete film indicated sufficient UV treatment through the full thickness of the material. In the case of Comparative Example C, the material did not cleanly separate from the top polyester layer indicating incomplete UV treatment through the thickness of the material.

These results show that the formulations with the fiber fillers can provide a consistent electrical connection after UV B-Stage while the formulations with only spherical particles require very high loading level for consistent electrical connection. Also, in the case of loading levels of 29 percent by weight the UV treatment allows for complete exposure and full film characteristic formation through the 5.5 mil thickness while in the case of the high spherical particle loading level (77 percent by weight), the material exhibited poor stencil printing characteristics and the UV light exposure did not allow for full film characteristic formation.

## Claims

1. A conductive adhesive precursor comprising:
a) from 20 to 50 percent by weight of at least one polyepoxide,
b) from 20 to 50 percent by weight of at least one free-radically polymerizable (meth)acrylate,
c) from 20 to 40 percent by weight of conductive fibers, and
d) from 2 to 10 percent by weight of conductive substantially spherical particles, wherein the percent by weight of components a) to d) is based on the total weight of components a) to d);
e) an effective amount of at least one thixotrope that is in a sufficient quantity that the conductive adhesive precursor rapidity develop shape stability and essentially eliminates flow after application of the conductive adhesive precursor to a substrate:
f) an effective amount of photoinitiator for the at least one free-radically polymerizable (meth)acrylate such that the conductive adhesive precursor can be sufficiently curent to B-stage upon photopolymerization; and
g) an effective amount of thermal curative for the at least one polyepoxide such that the conductive adhesive precursor can be sufficiently curent to develop a strong bond between two substrates.

2. The conductive adhesive precursor of claim 1, wherein the at least one free-radically polymerizable (meth)acrylate comprises at least one mono(meth)acrylate and at least one poly(meth)acrylate.

3. The conductive adhesive precursor of claim 1 or 2, wherein the conductive adhesive precursor is essentially solvent-free.

4. A method of conductively bonding a first substrate to a second substrate comprising:
applying a conductive adhesive precursor to the first substrate, the conductive adhesive precursor comprising:
a) from 20 to 50 percent by weight of at least one polyepoxide,
b) from 20 to 50 percent by weight of at least one free-radically polymerizable (meth)acrylate,
c) from 20 to 40 percent by weight of conductive fibers, and
d) from 2 to 10 percent by weight of conductive substantially spherical particles, wherein the percent by weight of each of components a) to d) is based on the total weight of components a) to d),
e) an effective amount of at least one thixotrope that is in a sufficient quantity that the conductive adhesive precursor rapidity develop shape stability and essentially eliminates flow after application of the conductive adhesive precursor to a substrate:
f) an effective amount of initiator for the at least one free-radically polymerizable (meth)acrylate such that the conductive adhesive precursor can be sufficiently curent to B-stage upon photopolymerization; and that is in a sufficient quantity that the conductive adhesive precursor rapidity develop shape stability and essentially eliminates flow after application of the conductive adhesive precursor to a substrate:
g) an effective amount of thermal curative for the at least one polyepoxide such that the conductive adhesive precursor can be sufficiently curent to develop a strong bond between two substrates.
free-radically polymerizing at least a portion of the at least one free-radically polymerizable (meth)acrylate to convert the conductive adhesive precursor into a B-staged conductive adhesive precursor,
contacting the second substrate with the B-staged conductive adhesive precursor; and
curing at least a portion of the at least one polyepoxide.

5. The method of claim 4, wherein the at least one free-radically polymerizable (meth)acrylate comprises at least one mono(meth)acrylate and at least one poly(meth)acrylate.

6. The method of claim 4 or 5, wherein the conductive adhesive precursor is essentially solvent-free.

7. The method of any one of claims 4 to 6, wherein the first substrate and the second substrate comprise electronic device components.

8. The method of any one of claims 4 to 7, wherein the B-staged conductive adhesive precursor is tacky.

9. An article comprising a first substrate bonded to a second substrate by a conductive adhesive, the conductive adhesive comprising a reaction product of a conductive adhesive precursor comprising:
a) from 20 to 50 percent by weight of at least one polyepoxide,
b) from 20 to 50 percent by weight of at least one free-radically polymerizable (meth)acrylate,
c) from 20 to 40 percent by weight of conductive fibers, and
d) from 2 to 10 percent by weight of substantially spherical conductive particles, wherein the percent by weight of components a) to d) is based on the total weight of components a) to d);
e) an effective amount of at least one thixotrope that is in a sufficient quantity that the conductive adhesive precursor rapidity develop shape stability and essentially eliminates flow after application of the conductive adhesive precursor to a substrate:
f) an effective amount of initiator for the at least one free-radically polymerizable (meth)acrylate such that the conductive adhesive precursor can be sufficiently curent to B-stage upon photopolymerization; and that is in a sufficient quantity that the conductive adhesive precursor rapidity develop shape stability and essentially eliminates flow after application of the conductive adhesive precursor to a substrate:
g) an effective amount of thermal curative for the at least one polyepoxide such that the conductive adhesive precursor can be sufficiently curent to develop a strong bond between two substrates.

10. The article of claim 9, wherein the at least one free-radically polymerizable (meth)acrylate comprises at least one mono(meth)acrylate and at least one poly(meth)acrylate.

11. The article of claim 9 or 10, wherein the conductive adhesive precursor is essentially solvent-free.

12. The article of any one of claims 9 to 11, wherein the first substrate and the second substrate comprise electronic device components.

## Patentansprüche

1. Vorläufer für einen leitfähigen Klebstoff, umfassend:
a) 20 bis 50 Gewichtsprozent mindestens eines Polyepoxids,
b) 20 bis 50 Gewichtsprozent mindestens eines radikalisch polymerisierbaren (Meth)acrylats,
c) 20 bis 40 Gewichtsprozent leitfähige Fasern und
d) 2 bis 10 Gewichtsprozent leitfähige weitgehend kugelförmige Teilchen, wobei sich der Gewichtsprozentanteil der Komponenten a) bis d) auf das Gesamtgewicht der Komponenten a) bis d) bezieht;
e) eine wirksame Menge mindestens eines Thixotrops, das in einer solchen Menge vorliegt, daß der Vorläufer für einen leitfähigen Klebstoff schnell Formstabilität entwickelt und nach dem Aufbringen des Vorläufers für einen leitfähigen Klebstoff auf ein Substrat Fließen im wesentlichen eliminiert;
f) eine wirksame Menge Photoinitiator für das mindestens eine radikalisch polymerisierbare (Meth)acrylat, so daß der Vorläufer für einen leitfähigen Klebstoff bei Photopolymerisation so weit gehärtet werden kann, daß er im B-Zustand vorliegt; und
g) eine wirksame Menge thermischen Härter für das mindestens eine Polyepoxid, so daß der Vorläufer für einen leitfähigen Klebstoff so weit gehärtet werden kann, daß sich eine starke Bindung zwischen zwei Substraten entwickelt.

2. Vorläufer für einen leitfähigen Klebstoff nach Anspruch 1, wobei das mindestens eine radikalisch polymerisierbare (Meth)acrylat mindestens ein Mono(meth)acrylat und mindestens ein Poly(meth)acrylat umfaßt.

3. Vorläufer für einen leitfähigen Klebstoff nach Anspruch 1 oder 2, wobei der Vorläufer für einen leitfähigen Klebstoff im wesentlichen lösungsmittelfrei ist.

4. Verfahren zum leitfähigen Verbinden eines ersten Substrats mit einem zweiten Substrat, bei dem man:
auf das erste Substrat einen Vorläufer für einen leitfähigen Klebstoff aufbringt, wobei der Vorläufer für einen leitfähigen Klebstoff:
a) 20 bis 50 Gewichtsprozent mindestens eines Polyepoxids,
b) 20 bis 50 Gewichtsprozent mindestens eines radikalisch polymerisierbaren (Meth)acrylats,
c) 20 bis 40 Gewichtsprozent leitfähige Fasern und
d) 2 bis 10 Gewichtsprozent leitfähige weitgehend kugelförmige Teilchen, wobei sich der Gewichtsprozentanteil jeder der Komponenten a) bis d) auf das Gesamtgewicht der Komponenten a) bis d) bezieht;
e) eine wirksame Menge mindestens eines Thixotrops, das in einer solchen Menge vorliegt, daß der Vorläufer für einen leitfähigen Klebstoff schnell Formstabilität entwickelt und nach dem Aufbringen des Vorläufers für einen leitfähigen Klebstoff auf ein Substrat Fließen im wesentlichen eliminiert;
f) eine wirksame Menge Initiator für das mindestens eine radikalisch polymerisierbare (Meth)acrylat, so daß der Vorläufer für einen leitfähigen Klebstoff bei Photopolymerisation so weit gehärtet werden kann, daß er im B-Zustand vorliegt; und
g) eine wirksame Menge thermischen Härter für das mindestens eine Polyepoxid, so daß der Vorläufer für einen leitfähigen Klebstoff so weit gehärtet werden kann, daß sich eine starke Bindung zwischen zwei Substraten entwickelt;
umfaßt;
mindestens einen Teil des mindestens einen radikalisch polymerisierbaren (Meth)acrylats radikalisch polymerisiert, wodurch der Vorläufer für einen leitfähigen Klebstoff in einen Vorläufer für einen leitfähigen Klebstoff im B-Zustand umgewandelt wird;
das zweite Substrat mit dem Vorläufer für einen leitfähigen Klebstoff im B-Zustand in Berührung bringt und
mindestens einen Teil des mindestens einen Polyepoxids härtet.

5. Verfahren nach Anspruch 4, bei dem das mindestens eine radikalisch polymerisierbare (Meth)acrylat mindestens ein Mono(meth)acrylat und mindestens ein Poly(meth)acrylat umfaßt.

6. Verfahren nach Anspruch 4 oder 5, bei dem der Vorläufer für einen leitfähigen Klebstoff im wesentlichen lösungsmittelfrei ist.

7. Verfahren nach einem der Ansprüche 4 bis 6, bei dem das erste Substrat und das zweite Substrat Bauteile elektronischer Vorrichtungen umfassen.

8. Verfahren nach einem der Ansprüche 4 bis 7, bei dem der Vorläufer für einen leitfähigen Klebstoff im B-Zustand klebrig ist.

9. Gegenstand, umfassend ein erstes Substrat, das durch einen leitfähigen Klebstoff mit einem zweiten Substrat verbunden ist, wobei der leitfähige Klebstoff ein Reaktionsprodukt eines Vorläufers für einen leitfähigen Klebstoff, umfassend:
a) 20 bis 50 Gewichtsprozent mindestens eines Polyepoxids,
b) 20 bis 50 Gewichtsprozent mindestens eines radikalisch polymerisierbaren (Meth)acrylats,
c) 20 bis 40 Gewichtsprozent leitfähige Fasern und
d) 2 bis 10 Gewichtsprozent leitfähige weitgehend kugelförmige Teilchen, wobei sich der Gewichtsprozentanteil der Komponenten a) bis d) auf das Gesamtgewicht der Komponenten a) bis d) bezieht;
e) eine wirksame Menge mindestens eines Thixotrops, das in einer solchen Menge vorliegt, daß der Vorläufer für einen leitfähigen Klebstoff schnell Formstabilität entwickelt und nach dem Aufbringen des Vorläufers für einen leitfähigen Klebstoff auf ein Substrat Fließen im wesentlichen eliminiert;
f) eine wirksame Menge Initiator für das mindestens eine radikalisch polymerisierbare (Meth)acrylat, so daß der Vorläufer für einen leitfähigen Klebstoff bei Photopolymerisation so weit gehärtet werden kann, daß er im B-Zustand vorliegt; und
g) eine wirksame Menge thermischen Härter für das mindestens eine Polyepoxid, so daß der Vorläufer für einen leitfähigen Klebstoff so weit gehärtet werden kann, daß sich eine starke Bindung zwischen zwei Substraten entwickelt;
umfaßt.

10. Gegenstand nach Anspruch 9, wobei das mindestens eine radikalisch polymerisierbare (Meth)acrylat mindestens ein Mono(meth)acrylat und mindestens ein Poly(meth)acrylat umfaßt.

11. Gegenstand nach Anspruch 9 oder 10, wobei der Vorläufer für einen leitfähigen Klebstoff im wesentlichen lösungsmittelfrei ist.

12. Gegenstand nach einem der Ansprüche 9 bis 11, wobei das erste Substrat und das zweite Substrat Bauteile elektronischer Vorrichtungen umfassen.

## Revendications

1. Précurseur d'adhésif conducteur comprenant :
a) de 20 à 50 pour cent en poids d'au moins un polyépoxyde,
b) de 20 à 50 pour cent en poids d'au moins un (méth)acrylate polymérisable par voie radicalaire,
c) de 20 à 40 pour cent en poids de fibres conductrices, et
d) de 2 à 10 pour cent en poids de particules conductrices sensiblement sphériques, dans lequel le pourcentage en poids des composants a) à d) est basé sur le poids total des composants a) à d) ;
e) une quantité efficace d'au moins un agent thixotrope qui est en quantité suffisante pour que le précurseur d'adhésif conducteur développe rapidement une stabilité de forme et supprime pratiquement tout écoulement après application du précurseur d'adhésif conducteur à un substrat ;
f) une quantité efficace de photoinitiateur pour l'au moins un (méth)acrylate polymérisable par voie radicalaire de telle sorte que le précurseur d'adhésif conducteur puisse être suffisamment durci jusqu'au stade B lors de la photopolymérisation ; et
g) une quantité efficace de durcisseur thermique pour l'au moins un polyépoxyde de telle sorte que le précurseur d'adhésif conducteur puisse être suffisamment durci pour développer une forte cohésion entre deux substrats.

2. Précurseur d'adhésif conducteur selon la revendication 1, dans lequel l'au moins un (méth)acrylate polymérisable par voie radicalaire comprend au moins un mono(méth)acrylate et au moins un poly(méth)acrylate.

3. Précurseur d'adhésif conducteur selon la revendication 1 ou 2, le précurseur d'adhésif conducteur étant pratiquement exempt de solvant.

4. Procédé pour coller de façon conductrice un premier substrat à un deuxième substrat comprenant :
l'application d'un précurseur d'adhésif conducteur au premier substrat, le précurseur d'adhésif conducteur comprenant :
a) de 20 à 50 pour cent en poids d'au moins un polyépoxyde,
b) de 20 à 50 pour cent en poids d'au moins un (méth)acrylate polymérisable par voie radicalaire,
c) de 20 à 40 pour cent en poids de fibres conductrices, et
d) de 2 à 10 pour cent en poids de particules conductrices sensiblement sphériques, dans lequel le pourcentage en poids de chacun des composants a) à d) est basé sur le poids total des composants a) à d) ;
e) une quantité efficace d'au moins un agent thixotrope qui est en quantité suffisante pour que le précurseur d'adhésif conducteur développe rapidement une stabilité de forme et supprime pratiquement tout écoulement après application du précurseur d'adhésif conducteur à un substrat ;
f) une quantité efficace d'initiateur pour l'au moins un (méth)acrylate polymérisable par voie radicalaire de telle sorte que le précurseur d'adhésif conducteur puisse être suffisamment durci jusqu'au stade B lors de la photopolymérisation ; et
g) une quantité efficace de durcisseur thermique pour l'au moins un polyépoxyde de telle sorte que le précurseur d'adhésif conducteur puisse être suffisamment durci pour développer une forte cohésion entre deux substrats ;
la polymérisation radicalaire d'au moins une partie de l'au moins un (méth)acrylate polymérisable par voie radicalaire pour transformer le précurseur d'adhésif conducteur en un précurseur d'adhésif conducteur au stade B ;
la mise en contact du deuxième substrat avec le précurseur d'adhésif conducteur au stade B ; et
le durcissement d'au moins une partie de l'au moins un polyépoxyde.

5. Procédé selon la revendication 4, dans lequel l'au moins un (méth)acrylate polymérisable par voie radicalaire comprend au moins un mono(méth)acrylate et au moins un poly(méth)acrylate.

6. Procédé selon la revendication 4 ou 5, dans lequel le précurseur d'adhésif conducteur est pratiquement exempt de solvant.

7. Procédé selon l'une quelconque des revendications 4 à 6, dans lequel le premier substrat et le deuxième substrat comprennent des composants de dispositif électronique.

8. Procédé selon l'une quelconque des revendications 4 à 7, dans lequel le précurseur d'adhésif conducteur au stade B est poisseux.

9. Article comprenant un premier substrat collé à un deuxième substrat par un adhésif conducteur, l'adhésif conducteur comprenant un produit de réaction d'un précurseur d'adhésif conducteur comprenant :
a) de 20 à 50 pour cent en poids d'au moins un polyépoxyde,
b) de 20 à 50 pour cent en poids d'au moins un (méth)acrylate polymérisable par voie radicalaire,
c) de 20 à 40 pour cent en poids de fibres conductrices, et
d) de 2 à 10 pour cent en poids de particules conductrices sensiblement sphériques, dans lequel le pourcentage en poids des composants a) à d) est basé sur le poids total des composants a) à d) ;
e) une quantité efficace d'au moins un agent thixotrope qui est en quantité suffisante pour que le précurseur d'adhésif conducteur développe rapidement une stabilité de forme et supprime pratiquement tout écoulement après application du précurseur d'adhésif conducteur à un substrat ;
f) une quantité efficace d'initiateur pour l'au moins un (méth)acrylate polymérisable par voie radicalaire de telle sorte que le précurseur d'adhésif conducteur puisse être suffisamment durci jusqu'au stade B lors de la photopolymérisation ; et
g) une quantité efficace de durcisseur thermique pour l'au moins un polyépoxyde de telle sorte que le précurseur d'adhésif conducteur puisse être suffisamment durci pour développer une forte cohésion entre deux substrats.

10. Article selon la revendication 9, dans lequel l'au moins un (méth)acrylate polymérisable par voie radicalaire comprend au moins un mono(méth)acrylate et au moins un poly(méth)acrylate.

11. Article selon la revendication 9 ou 10, dans lequel le précurseur d'adhésif conducteur est pratiquement exempt de solvant.

12. Article selon l'une quelconque des revendications 9 à 11, dans lequel le premier substrat et le deuxième substrat comprennent des composants de dispositif électronique.
